**Europäisches Patentamt**

(19) **European Patent Office**

**Office européen des brevets**

(11) Veröffentlichungsnummer: **0 098 997**
**B1**

(12) **EUROPÄISCHE PATENTSCHRIFT**

(45) Veröffentlichungstag der Patentschrift: 05.09.90

(51) Int. Cl.⁵: **H 01 L 31/111**

(21) Anmeldenummer: **83106052.0**

(22) Anmeldetag: **21.06.83**

(54) **Lichtzündbarer Thyristor mit geringem Lichtleistungsbedarf.**

(30) Priorität: **16.07.82 DE 3226613**

(43) Veröffentlichungstag der Anmeldung:
**25.01.84 Patentblatt 84/04**

(45) Bekanntmachung des Hinweises auf die
Patenterteilung:
**05.09.90 Patentblatt 90/36**

(84) Benannte Vertragsstaaten:
**CH DE FR GB LI SE**

(56) Entgegenhaltungen:
**EP-A-0 021 086**
**EP-A-0 040 817**
**EP-A-0 098 998**
**DE-A-2 408 079**
**PATENT ABSTRACTS OF JAPAN, Band 5, Nr,**
**198 (E-87) (870), 16. Dezember 1981 & JP-A-56-**
**120 161**
**PATENT ABSTRACTS OF JAPAN, Band 5, Nr,**
**117 (E-67) (789) 28. Juli 1981 & JP-A-56-56 671**
**Buch: "Thyristoren" W. Gerlach, Springer Verlag**
**Berlin 1979 (Seite 393)**

(73) Patentinhaber: **Siemens Aktiengesellschaft**
**Wittelsbacherplatz 2**
**D-8000 München 2 (DE)**

(72) Erfinder: **Herberg, Helmut, Dr.**
**Bruderhofstrasse 30a**
**D-8000 München 70 (DE)**

Courier Press, Leamington Spa, England.

## Beschreibung

Die Erfindung bezieht sich auf einen lichtzündbaren Thyristor nach dem Oberbegriff des Patentanspruchs 1 und auf ein Verfahren zu seinem Betrieb.

Ein Thyristor dieser Art ist aus dem Buch von W. Gerlach "Thyristoren", Springer-Verlag Berlin, 1979, Seiten 393 bis 394 bekannt. Hier wird ein sich bis zur Oberfläche des Halbleiterkörpers erstreckender Ansatz der n-Basis bei der Zündung direkt beleuchtet. Unter dem Einfluß einer hinreichend großen Blockierspannung füllt die Raumladungszone, die sich am pn-Übergang zwischen der p-Basis und der n-Basis aufbaut, den Ansatz der n-Basis fast vollständig aus. Das ergibt einen guten Wirkungsgrad bei der belichtungsabhängigen Erzeugung von Elektronen und Defektelektronen, aus denen der Zündstrom resultiert, so daß der Thyristor eine große Fotoempfindlichkeit hat.

Aus der EP—A—0 040 817 ist ein lichtzündbarer Thyristor bekannt, bei dem eine einen Fototransistor enthaltende, lichtempfindliche Schaltung zwischen die kathodenseitige Elektrode und eine die n-Basis kontaktierende Elektrode geschaltet ist. Da die letztgenannte Elektrode die n-Basis jedoch in dem der p-Basis benachbarten Teil kontaktiert, wird der mit dieser Elektrode verbundene Anschluß des Fototransistors fast mit der vollen Blockierspannung beaufschlagt, die jeweils am Thyristor anliegt.

Der Erfindung liegt die Aufgabe zugrunde, einen Thyristor der eingangs genannten Art so auszubilden, daß er trotz einer hohen Sperrfähigkeit und insbesondere trotz einer höhen kritischen Spannungsanstiegeschwindigkeit dU/dt in Bezug auf eine zwischen den anoden- und kathodenseitigen Elektroden anliegende, den Thyristor in Durchlaßrichtung polende Spannung U mit einer sehr geringen Lichtleistung gezündet werden kann. Gemäß der Erfindung wird dies durch die in kennzeichnenden Teil des Patentanspruchs 1 angeführten Merkmale erreicht.

Der mit der Erfindung erzeilbare Vorteil besteht insbesondere darin, daß das lichtempfindliche Schaltelement eine relativ niedrige Sperrfähigkeit und eine hiermit zu vereinbarende große Fotoempfindlichkeit aufweisen kann, ohne daß die wesentlich größere Sperrfähigkeit des aus dem Thyristor und des Schaltelement bestehenden Systems beeinrächtigt wird. Für dieses System läßt sich also eine weitgehende Entkopplung der beiden Parameter Sperrfähigkeit und Zündempfindlichkeit erreichen.

Die Ansprüche 2 bis 10 sind auf bevorzugte Weiterbildungen und Ausgestaltungen der Erfindung gerichtet, während der Anspruch 11 ein bevorzugtes Verfahren zum Betrieb eines erfindungsgemäßen Thyristors betrifft.

Die Erfindung wird nachfolgend anhand der Zeichnung näher erläutert. Dabei zeigen:

Figur 1 den Querschnitt eines ersten Ausführungsbeispiels der Erfindung,

Figur 2 den Verlauf der sich längs des pn-Übergangs zwischen der p-Basis und der n-Basis ausbildenden Raumladungszone bei einer kleinen Blockierspannung,

Figur 3 den Verlauf dieser Raumladungszone bei einer großen Blockierspannung,

Figuren 4 bis 7 weitere Ausführungsbeispiele der Erfingung und

Figur 8 eine integrierte Ausführungsform des Ausführungsbeispiels nach Figur 1.

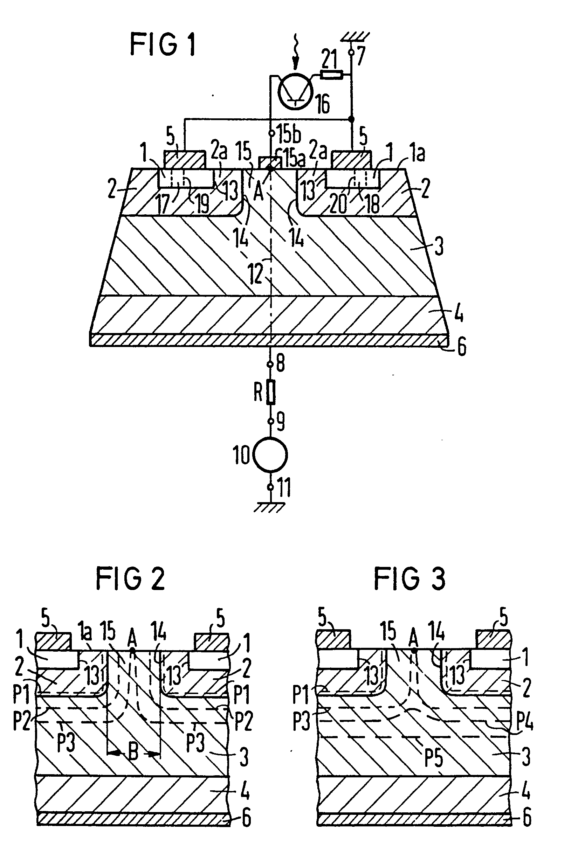

In Figur 1 ist ein Thyristor mit einem Halbleiterkörper aus dotiertem Halbleitermaterial, z. B. Silizium, dargestellt, der vier aufeinanderfolgende Schichten abwechselnder Leitungstypen aufweist. Bei diesen handelt es sich um den n-Emitter 1, die p-Basis 2, die n-Basis 3 und den p-Emitter 4. Der n-Emitter 1 ist mit einer kathodenseitigen Elektrode 5 versehen, der p-Emitter 4 mit einer anodenseitigen Elektrode 6, wobei die Elektroden aus einem elektrisch leitenden Material, z. B. Aluminium, bestehen. Die Elektrode 5 ist über einen Anschluß 7 mit Masse verbunden, die Elektrode 6 über einen Anschluß 8 und einen Lastwiderstand R mit dem oberen Anschluß 9 einer Spannungsquelle 10, deren unterer Anschluß 11 auf Masse liegt.

Die p-Basis 2 weist einen Ansatz 2a auf, der sich bis zu der kathodenseitigen Grenzfläche 1a des Halbleiterkörpers erstreckt. Bei einem rotationssymmetrischen Thyristoraufbau, der durch eine strichpunktierte Symmetrieachse 12 angedeutet ist, sind die Teile 1 und 5 ringförmig ausgebildet, wobei 13 eine zentrale Ausnehmung des n-Emitters 1 bezeichnet, die von einem zentrischen Ansatz 2a ausgefüllt wird. Besitzt der n-Emitter 1 dagegen eine Streifenstruktur, was so zu verstehen ist, daß die dargestellten Teile 1 und 5 streifenförmig ausgebildet sind und zum Beispiel senkrecht zur Bildebene von Figur 1 über die gesamte Grenzfläche 1a oder über wesentliche Teile derselben verlaufen, so stellt der Ansatz 2a einen ebenfalls streifenförmigen Steg dar, der die Teile 1 voneinander trennt. Dabei können die Teile 1 an ihren Enden derart miteinander verbunden sein, daß ein U-förmige Emitterstruktur entsteht. Die Teile 1 können auch so ausgestaltet sein, daß sie in der Oberfläche 1a nach einer beliebigen Kurve (Spirale oder dergleichen) verlaufen. Der Ansatz 2a der p-Basis 2 hat eine Ausnehmung 14, die von einem Ansatz 15 der n-Basis 3 ausgefüllt wird, welcher sich bis zur Grenzfläche 1a erstreckt. Die Ausnehmung 14 und der Ansatz 15 können dabei entsprechend dem Ansatz 2a kreisförmig oder streifenförmig ausgebildet sein.

Figur 2 zeigt den Verlauf der Raumladungszone, die sich in Figur 1 bei einer kleinen Blockierspannung zwischen den Anschlüssen 7 und 8 an dem in Sperrichtung gepolten pn-Übergang zwischen der p-Basis 2 und der n-Basis 3 ergibt, während Figur 3 den Verlauf dieser Raumladungszone bei einer großen Blockierspannung darstellt. Mit P1 bis P5 sind Äquipotentiallinien bezeichnet, die jeweils festen Potentialwerten entsprechen. Geht man in Figur 2 davon aus, daß die Elektrode 5 auf Masse liegt und die Elektrode 6 mit einer Blockierspannung U1 beschaltet ist, so entspricht die Linie P1, die die Raumladungszone nach oben begrenzt, einem sehr kleinen Potentialwert, der sich nur wenig von Null unterscheidet, P2 einem mittleren Potentialwert und die Linie P3, die die Raumladungszone nach unten begrenzt, einem Potentialwert, der etwa dem Spannungswert U1 entspricht. Dabei weist auch der Punkt A in der Oberfläche 1a den Potentialwert P3 auf. U1 sei dabei so gewählt, daß sich die etwa senkrecht verlaufenden Abschnitte der Äquipotentiallinien P3 im Punkte A treffen. Bei einer Breite B des Ansatzes 15 von ca. 50 bis 200 μm liegt die Spannung U1, bei der eine Konfiguration der Raumladungszone nach Figur 2 auftritt, je nach dem Dotierungsgrad der n-Basis 3 zum Beispiel zwischen 20 und 200 Volt. Wird nun die Spannung an der Elektrode 6 über U1 hinaus erhöht (Figur 3), so vergrößert sich die Raumladungszone, was durch die hinzutretenden Äquipotentiallinien P4 und P5 angedeutet ist. P5 begrenzt dann die Raumladungszone nach unten und bezeichnet einen Potentialwert, der etwa der erhöhten Spannung an der Elektrode 6 entspricht. Wesentlich ist hierbei, daß jede Erhöhung der Spannung an der Elektrode 6 bis zum Wert U1 eine entsprechende Erhöhung des Potentials am Punkt A zur Folge hat, während jede Erhöhung über den Wert U1 hinaus das Potential im Punkt A praktisch nicht mehr verändert.

Der Ansatz 15 der n-Basis 3 wird im Bereich des Punktes A (Figur 1) mit einer Elektrode 15a aus elektrisch leitendem Material, zum Beispiel Aluminium, versehen, die über einen Anschluß 15b und über die Schaltstrecke eines Fototransistors 16 mit dem Anschluß 7 der kathodenseitigen Elektrode 5 verbunden ist.

Wird der Fototransistor 16 beleuchtet, so wird über seine Schaltstrecke eine niederohmige Verbindung zwischen dem Anschluß 7 und der n-Basis 3 aufgebaut. Bei gleichzeitigem Anliegen einer von 10 erzeugten Blockierspannung, die die Elektrode 6 positiv gegenüber der Elektrode 5 vorspannt, verhält sich der Halbleiterkörper wie eine aus den Teilen 3 und 4 bestehende Halbleiterdiode die in Durchlaßrichtung gepolt ist. Über die Elektrode 15 beginnt ein Zündstrom zu fließen, der zu einer raschen Zündung des Thyristors führt. Das Löschen des Thyristors geschieht bei einer Gleichspannungsquelle 10 beispielsweise durch Abschaltung derselben und bei einer Wechselspannungsquelle 10 etwa im nächstfolgenden Nulldurchgang der bei 8 anliegenden Spannung.

Die Zündempfindlichkeit der gesamten Anordnung nach Figur 1 ist um so größer, je größer die Fotoempfindlichkeit des Fototransistors 16 ist. Nach der Erfindung ist es daher zweckmäßig, einen Fototransistor 16 mit großer Fotoempfindlichkeit zu verwenden. Da die Spannung im Punkt A und damit die Spannung am Fototransistor 16 den Wert U1 praktisch nicht überschreitet, genügt es, die Sperrfähigkeit des Fototransistors 16 der Spannung U1 anzupassen. Das gilt auch für den Fall, daß eine wesentlich größere Spannung zwischen den Elektroden 5 und 6 anliegt. Oberhalb von U1 können sich auch hohe Spannungsanstiegsgeschwindigkeiten dU/dt einer bei 8 anliegenden Spannung U auf die Betriebsweise des Fototransistors 16 nicht negativ auswirken. Die Sperrfähigkeit des aus des Thyristor unf dem Fototransistor 16 bestehenden Systems gegenüber hohen Blockierspannungen am Anschluß 8 wird durch die große Sperrfähigkeit des Thyristors bestimmt, die in an sich bekannter Weise, zum Beispiel durch das Anbringen von festen Emitter-Kurzschlüssen am n-Emitter 1, noch erhöht werden kann. Unter diesen Emitter-Kurzschlüssen werden Ansätze 17, 18 der p-Basis 2 verstanden, die entsprechende Ausnehmungen 19, 20 des n-Emitters 1 ausfüllen und sich bis zur Oberfläche 1a erstrecken, in der sie von der Elektrode 5 kontaktiert werden.

Zur Begrenzung des über den Fototransistor 16 fließenden Zündstroms ist ein Widerstand 21 in Serie zur Transistor-Schaltstrecke vorgesehen.

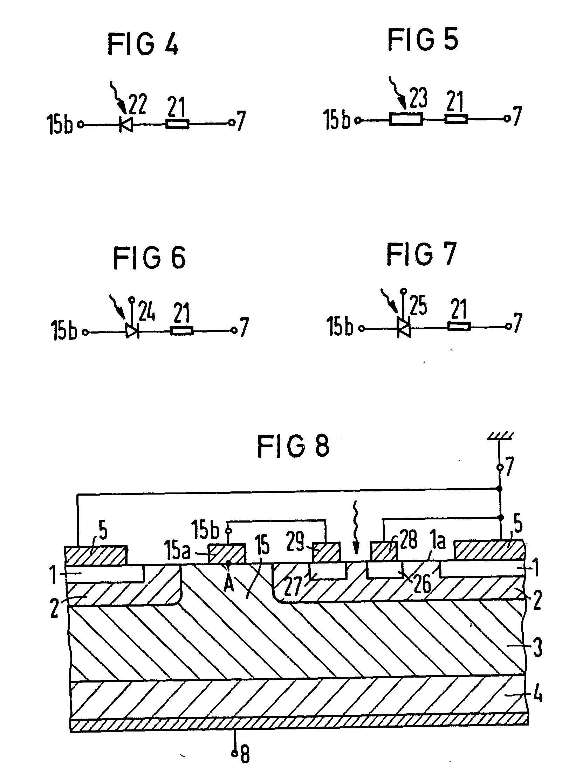

Im Rahmen der Erfindung kann anstelle des Fototransistors 16 auch ein anderes lichtempfindliches Schaltelement vorgesehen sein. Beispiele hierfür sind den Figuren 4 bis 7 zu entnehmen. Im einzelnen zeigt Figur 4 eine Fotodiode 22, Figur 5 einen Fotowiderstand 23, Figur 6 einen Fotothyristor 24 und Figur 7 einen Opto-Triac 25, die jeweils zwischen die Anschlüsse 15b und 7 von Figur 1 geschaltet sind. Die optoelektronischen Bauelemente 16 und 22 bis 24 sind an sich bekannt und beispielsweise in dem Buch von G. Harzinger "Optoelektronische Bauelemente und Schaltungen", herausgegeben von der Siemens Aktiengesellschaft, Berlin, München, 1977, auf den Seiten 36 bis 41, 55 bis 66, 76 und 77 beschrieben. Ein Opto-Triac 25 ist beispielsweise in den Tagungsunterlagen des Instituts für Angewandte Festkörperphysik, Freiburg i. Br., zum 10. Kolloquim "Halbleiterleistungs-Bauelemente und Materialgüte SI", 2. und 3. November 1981, betreffend den Beitrag "Neueste Ergebnisse von SIPMOS Opto-Triacs" von L. Leipold, beschrieben.

Das lichtempfindliche Schaltelement muß in der erfindungsgemäßen Schaltung lediglich der Bedingung genügen, daß es unter Lichteinfluß zwischen den Anschlüssen 15b und 7 eine niederohmige Verbindung herstellt. Im Falle des Fototransistors 16 und der Fotodiode 22 fließt unter Lichteinfluß allerdings lediglich der Fotostrom über die Elektrode 15a, während bei den übrigen lichtempfindlichen Schaltelementen unter Lichteinwirkung über die Elektrode 15a ein Zündstrom fließt, der dem Lastkreis R, 10, 7, 8 entnommen wird.

Der Fotothyristor 24 und der Opto-Triac 25 können sehr zündempfindlich ausgebildet sein, da die hiermit zu verbindende kleine Sperrfähigkeit und kleine kritische Spannungsanstiegsgeschwindigkeit dU/dt lediglich an die am Anschluß 15b bzw. am Punkt A auftretende Spannung U' angepaßt werden müssen, die maximal einen Wert von etwa U1 erreicht.

Eine bevorzugte Weiterbildung des Thyristors nach der Erfindung besteht darin, daß eine Mehrzahl der in Figur 1 an der Oberfläche 1a liegenden

Strukturen nebeneinander an einer entsprechend vergrößerten Grenzfläche eines Halbleiterkörpers angeordnet sind, dessen laterale Abmessungen ein Mehrfaches des in Figur 1 dargestellten betragen. Dabei können streifenförmig ausgebildete Emitter 1 insbesondere parallel zueinander verlaufen. Bei einem rotationssymmetrischen Aufbau um die Symmetrieachse 12 sind die weiteren an der Oberfläche 1a liegenden Strukturen zweckmäßigerweise konzentrisch um die in Figur 1 dargestellte Struktur angeordnet. Jede dieser weiteren Strukturen kann anhand von Figur 1 veranschaulicht werden, wenn man den Strukturen 1, 2, 2a, 5, 15 und 15a nicht die Achse 12 sondern eine rechts außerhalb des Halbleiterkörpers liegende, zu 12 parallele Symmetrieachse zuordnet. Die einzelnen Strukturen sind mit Vorteil über ihre Anschlüsse 15b und 7 zueinander parallel geschaltet, so daß ein lichtempfindliches Schaltelement, z. B. 16, allen gemeinsam ist.

Die lichtempfindlichen Schaltelemente 16 uzw. können als externe Bauelemente ausgebildet und mit den Thyristoranschlüssen 15b und 7 verbunden sein oder auch in den Halbleiterkörper des Thyristors integriert werden.

Eine solche integrierte Ausgestaltung des Ausführungsbeispiels nach Figur 1 ist in Figur 8 dargestellt. Dabei ist der Fototransistor 16 als ein bipolarer Transistor ausgebildet, dessen Emitter und Kollektor aus in die p-Basis 2 eingefügten, n-leitenden Gebieten 26 und 27 bestehen. Seine beleuchtbare Basis wird von dem zwischen den Gebieten 26 und 27 liegenden Teil der p-Basis 2 gebildet. Die Gebiete 26 und 27 werden in der Oberfläche 1a von Elektroden 28 und 29 kontaktiert, die jeweils mit den Anschlüssen 7 und 15b verbunden sind.

Ein Strombegrenzungswiderstand 21 wird zweckmäßigerweise auch in Serie zu den Schaltelementen 22 bis 25 vorgesehen.

## Patentansprüche

1. Lichtzündbarer Thyristor mit einem Halbleiterkörper, der einen von einer Kathodenseitigen Elektrode (5) kontaktierten n-Emitter (1) mit einer angrenzenden p-Basis (2) und einen von einer anodenseitigen Elektrode (6) kontaktierten p-Emitter (4) mit einer angrenzenden n-Basis (3) enthält, die ihrerseits an die p-Basis angrenzt, mit zwei Ansätzen (2a) oder Ansatzteilen der p-Basis, die sich bis zu der kathodenseitigen Oberfläche (1a) des Halbleiterkörpers erstrecken und mit einem zwischen diesen Ansätzen (2a) oder Ansatzteilen liegenden, sich ebenfalls bis zu dieser Oberfläche erstreckenden Ansatz (15) der n-Basis (3), gekennzeichnet durch ein lichtempfindliches Schaltelement (16, 22 bis 25), das zwischen eine den Ansatz (15) der n-Basis (3) kontaktierende Elektrode (15a) und die kathodenseitige Elektrode (5) geschaltet ist.

2. Lichtzündbarer Thyristor nach Anspruch 1, dadurch gekennzeichnet, daß das lichtempfindliche Schaltelement aus einem Fototransistor (16) besteht.

3. Lichtzündbarer Thyristor nach Anspruch 1, dadurch gekennzeichnet, daß das lichtempfindliche Schaltelement aus einer Fotodiode (22) besteht.

4. Lichtzündbarer Thyristor nach Anspruch 1, dadurch gekennzeichnet, daß das lichtempfindliche Schaltelement aus einem Fotowiderstand (23) besteht.

5. Lichtzündbarer Thyristor nach Anspruch 1, dadurch gekennzeichnet, daß das lichtempfindliche Schaltelement aus einem Fotothyristor (24) besteht.

6. Lichtzündbarer Thyristor nach Anspruch 1, dadurch gekennzeichnet, daß das lichtempfindliche Schaltelement aus einem Opto-Triac (25) besteht.

7. Lichtzündbarer Thyristor nach einem der Ansprüche 1 bis 6, dadurch gekennzeichnet, daß das lichtempfindliche Schaltelement (26, 27) in den Halbleiterkörper integriert ist.

8. Lichtzündbarer Thyristor nach einem der Ansprüche 1 bis 7, dadurch gekennzeichnet, daß ein Strombegrenzungswiderstand (21) in Serie zum lichtempfindlichen Schaltelement vorgesehen ist.

9. Lichtzündbarer Thyristor nach einem der Ansprüche 1 bis 8, dadurch gekennzeichnet, daß mehrere n-Emitter (1), Ansätze der p-Basis (2a) und der n-Basis (15), kathodenseitige Elektroden (5) und die Ansätze der n-Basis (15) kontaktierende Elektroden (15a) lateral nebeneinander auf einem gemeinsamen Halbleiterkörper vorgesehen sind.

10. Verfahren zum Betrieb des lichtzündbaren Thyristors nach Anspruch 1, dadurch gekennzeichnet, daß das lichtempfindliche Schaltelement (16) zum Zwecke der Zündung des Thyristors beleuchtet wird, so daß sich über das Schaltelement (16) eine niederohmige Verbindung zwischen der Zuleitung zur kathodenseitigen Elektrode (5) und der n-Basis (3) ausbildet.

## Revendications

1. Thyristor à amorçage par la lumière, avec un corps semiconducteur qui comporte un émetteur de type n (1) en contact avec une électrode (5) située du côté cathode, avec une base voisine du type p (2) et un émetteur du type p (4) en contact avec une électrode (6) située du côté anode, avec une base voisine du type n (3), qui, à son tour jouxte la base de type p, avec deux appendices (2a) ou éléments d'appendices de la base de type p, qui s'étendent jusqu'à la surface (1a), côté cathode, du corps semiconducteur et avec un appendice (15) de la base de type n (3), qui se situe entre ces appendices (2a) ou éléments d'appendices et qui s'étend également jusqu'à cette surface, caractérisé par un élément de commutation photosensible (16, 22 à 25) qui est monté entre une électrode (15a) en contact avec la base de type n (3) et l'électrode (5) située du côté cathode.

2. Thyristor à amorçage par la lumière selon la revendication 1, caractérisé par le fait que l'élément de commutation photosensible est constitué par un phototransistor (16).

3. Thyristor à amorçage par la lumière selon la revendication 1, caractérisé par le fait que l'élément de commutation photosensible est constitué par une photodiode (22).

4. Thyristor à amorçage par la lumière selon la revendication 1, caractérisé par la fait que l'élément de commutation photosensible est constitué par une photorésistance (23).

5. Thyristor à amorçage par la lumière selon la revendication 1, caractérisé par le fait que l'élément de commutation photosensible est constitué par un phototransistor (24).

6. Thyristor à amorçage par la lumière selon la revendication 1, caractérisé par le fait que l'élément de commutation photosensible est constitué par un triac optoélectronique (25).

7. Thyristor à amorçage par la lumière selon l'une des revendications 1 à 6, caractérisé par le fait que l'élément de commutation photosensible (26, 27) est intégré dans le corps semiconducteur.

8. Thyristor à amorçage par la lumière selon l'une des revendications 1 à 7, caractérisé par le fait qu'une résistance de limitation du courant (21) est prévue en série avec l'élément de commutation photosensible.

9. Thyristor à amorçage par la lumière selon l'une des revendications 1 à 8, caractérisé par le fait que plusieurs émetteurs du type n (1), plusieurs appendices de la base du type p (2a) et de la base du type n (15), plusieurs électrodes (5) situées du côté de la cathode et les électrodes (15a) qui sont reliées ou contactées avec les appendices de la base (15) de type n, sont prévu latéralement les uns à côté de autres sur un corps semiconducteur commun.

.10. Procédé pour la mise en oeuvre d'un thyristor à amorçage par la lumière selon la revendication 1 caractérisé par le fait que l'élément de commutation photosensible (16) est éclairé en vue de l'amorçage du thyristor, en sorte qu'il se forme, par l'intermédiaire de l'élément de commutation (16) une liaison faiblement ohmique entre le conducteur d'amenée de l'électrode (5) situé du côté de la cathode et la base (3) du type n.

**Claims**

1. Light-activatable thyristor having a semiconductor body, which includes a n-emitter (1), contacted by a cathode-side electrode (5), with an adjoining p-base (2), and p-emitter (4), contacted by an anode-side electrode (6), with an adjoining n-base (3), which, for its part, adjoins the p-base, having two tongues (2a) or tongue parts of the p-base, which extend up to the surface (1a) of the semiconductor body in the cathode circuit, and having a tongue (15) of the n-base (3) which is located between these tongues (2a) or tongue parts and likewise extends up to the surface, characterized by a photo-sensitive switch element (16, 22 to 25), which is switched between an electrode (15a) contacting the tongue (15) of the n-base (3) and the cathode-side electrode (5).

2. Light-activatable thyristor according to Claim 1, characterized in that the photo-sensitive switch element consists of a phototransistor (16).

3. Light-activatable thyristor according to Claim 1, characterized in that the photo-sensitive switch element consists of a photodiode (22).

4. Light-activatable thyristor according to Claim 1, chracterized in that the photo-sensitive switch element consists of a photoresistor (23).

5. Light-activatable thyristor according to Claim 1, characterized in that the photo-sensitive switch element consists of a photothyristor (24).

6. Light-activatable thyristor according to Claim 1, characterized in that the photo-sensitive switch element consists of an opto-triac (25).

7. Light-activatable thyristor according to one of Claims 1 to 6, characterized in that the photo-sensitive switch element (26, 27) is integrated into the semiconductor body.

8. Light-activatable thyristor according to one of Claims 1 to 7, characterized in that a current limiting resistor (21) is provided in series with the photo-sensitive switch element.

9. Light-activatable thyristor according to one of Claims 1 to 8, characterized in that a plurality of n-emitters (1), tongues of the p-base (2a) and of the n-base (15), cathode-side electrodes (5a) and electrodes (15a) contacting the tongues of the n-base (15) are provided laterally next to one another on a common semiconductor body.

10. Method of operating the light-activatable thyristor according to Claim 1, characterized in that the photo-sensitive switch element (16) is illuminated for the purpose of firing the thyristor, so that a low-resistance connection is formed via the switch element (16) between the supply lead to the cathode-side electrode (5) and the n-base (3).

# FIG 1

# FIG 2

# FIG 3

## FIG 4

15b o——▷|——22——[ 21 ]——o 7

## FIG 5

15b o——[ 23 ]——[ 21 ]——o 7

## FIG 6

15b o——▷|——24——[ 21 ]——o 7

## FIG 7

15b o——◁▷|——25——[ 21 ]——o 7

## FIG 8